(19) **Europäisches Patentamt / European Patent Office / Office européen des brevets**

(11) **EP 1 630 570 B1**

(12) **EUROPEAN PATENT SPECIFICATION**

(45) Date of publication and mention
of the grant of the patent:
**16.05.2007 Bulletin 2007/20**

(51) Int Cl.:
*G01S 7/03* *(2006.01)* *H01Q 21/00* *(2006.01)*
*H01Q 23/00* *(2006.01)* *H01Q 21/20* *(2006.01)*
*H01Q 25/00* *(2006.01)* *H01P 5/18* *(2006.01)*

(21) Application number: **05425462.8**

(22) Date of filing: **28.06.2005**

(54) **Transceiver module for a system of two phased array antennas**

Sende- und Empfangsmodul für ein System mit zwei phasengesteuerten Gruppenantennen

Module émetteur-récepteur pour un système avec deux réseaux d'antennes à commande de phase

(84) Designated Contracting States:
**AT BE BG CH CY CZ DE DK EE ES FI FR GB GR HU IE IS IT LI LT LU MC NL PL PT RO SE SI SK TR**
Designated Extension States:
**LV YU**

(30) Priority: **12.07.2004 IT RM20040345**

(43) Date of publication of application:
**01.03.2006 Bulletin 2006/09**

(73) Proprietor: **Elettronica S.p.A.**
**00131 Roma RM (IT)**

(72) Inventors:
• **Gemma, Maurizio,**
**c/o Elettronica S.p.A.**
**00131 Roma (IT)**
• **Giolo, Giancarlo,**
**c/o Elettronica S.p.A.**
**00131 Roma (IT)**

• **De Santis, Giovanni,**
**c/o Elettronica S.p.A.**
**00131 Roma (IT)**

(74) Representative: **Raimondi, Adriana et al**
**Cavattoni - Raimondi,**
**Viale dei Parioli, 160**
**00197 Roma (IT)**

(56) References cited:
**US-A- 5 369 381** **US-A1- 2003 112 184**

• **LYE HENG CHUA ET AL: "Design and analysis of coplanar Lange coupler for millimetre-wave applications up to 90 GHz" MICROWAVE CONFERENCE, 2000 ASIA-PACIFIC SYDNEY, NSW, AUSTRALIA 3-6 DEC. 2000, PISCATAWAY, NJ, USA, IEEE, US, 3 December 2000 (2000-12-03), pages 392-395, XP010544927 ISBN: 0-7803-6435-X**
• **HOM R L ET AL: "An automatic phase alignment system for transmitters" IEEE, 7 May 1990 (1990-05-07), pages 141-146, XP010007459**

**EP 1 630 570 B1**

**Description**

The present invention relates to a dual transceiver module, particularly for phased array antennae.

Modern microwave systems, such as radar systems, for many applications such as naval applications and for airspace surveillance systems, are required to cover angular sectors having a considerable aperture, commonly exceeding 180 degrees, switching from transmission to reception and vice versa, and positioning the emitted beam in an extremely precise way within times of the order of a few tens of nanoseconds, while varying the operating frequency, if necessary, within times of the same order of magnitude.

The known solution to this problem in the prior art is to use two adjacent phased array antennae, positioned in such a way that each covers a different spatial sector.

The present invention relates to a transceiver module which can provide this function by using a number of transceiver modules equal to half of those required for the conventional solution, with consequent benefits in terms of the overall dimensions and cost of the equipment.

US 2003/0112184A1 discloses a transceiver module for a phased array antenna, the module comprising a Lange coupler.

Reasons for development

In recent years, a category of antennae known as phased array antennae has undergone considerable development from the time when this was made possible by the development of active solid state microwave components to meet increasingly critical operating requirements.

The most advanced modern microwave systems, such as radar systems, are required to cover considerable angular sectors in both transmission and reception, and over a wide frequency range.

The conventional solution is to use two phased array antennae, positioned in such a way that each covers a different spatial sector, in which each radiating element is driven by an individual microwave module operating in both transmission and reception (denoted by "TX/RX" below).

An examination of this solution immediately reveals that it has numerous critical areas, such as:

-   the need to establish an RF signal distribution network which is extremely complex and difficult to adjust, for supplying the individual radiating elements of the two antennae (all the radio frequency paths must be in phase);
-   high cost; this is because the necessity of supplying each individual radiating element of each phased array antenna with a TX/RX module means that the cost of an antenna increases linearly with the rise in the number of these radiating elements.

Since the operating requirements for new radar systems necessitate a level of performance which can be achieved only with a very large number of radiating elements (as many as several thousand elements), the cost of a phased array antenna controlled by TX/RX modules becomes prohibitive as soon as more than a few tens of elements are needed. This was particularly true of cases in which, based on the technology available up to the end of the 1990s, the TX/RX modules were made by means of hybrid technology, in which each individual microwave function was provided by a thin-film device or circuit.

Recently, gallium arsenide (GaAs) technology has pointed the way toward the solution of this problem.

This because the use of gallium arsenide (GaAs) monolithic microwave circuits (MMICs) with a high degree of integration, combined with the use of automatic assembly and testing machines, has enabled the cost of an individual TX/RX module to be reduced by a factor of between 3 and 4, thus making equipment using solid state phased array antennae competitive.

The use of a particularly efficient circuit structure, as described below, has made it possible to halve the number of TX/RX modules required to drive a multi-section antenna.

Innovative aspect

The principal characterizing element of the TX/RX module according to the present invention is its ability to drive radiating elements of a phased array antenna positioned on planar surfaces not connected to each other, and, as a result of its circuit structure, its ability to use only 50% of the modules necessary in the conventional solution.

This is achieved by ensuring that the whole of the generated radio frequency power is available to each of the sections of the previously selected antenna, without any loss of efficiency in switching and with a performance which is absolutely identical to that obtainable when twice the number of modules are used.

The principal advantages of the solution according to the present invention are listed below:

- The number of TX/RX modules required to supply the antenna is halved.
- There is guaranteed technical performance identical to that of any equipment using one module to supply each individual radiating element.
- The complexity of the radio frequency distribution network between the equipment and the antenna is reduced.
- The times required for the construction, assembly and adjustment of the phased array antenna are considerably reduced.
- Finally, there is a considerable positive impact, which is very significant in percentage terms, on the cost of the antenna, which in modern radar equipment constitutes a highly significant proportion of the cost of the equipment.

The circuit design and the technology used to obtain the aforementioned characteristics are detailed below.

Microwave systems and the problem of azimuthal coverage

As mentioned above, modern microwave systems, whether of the radar or communications types, are commonly required to detect, analyze and/or transmit RF signals in regions of the surrounding space having a considerable angular amplitude, frequently exceeding 180 degrees, and sometimes, in order to obtain coverage in all directions, equal to 360 degrees (360° azimuthal coverage).
The operating requirements of present systems are also such that it must be possible to process the signals and position the antenna beam in any direction in times of the order of a few tens of nanoseconds.
During the development of microwave systems, the appearance of these requirements has led to the exclusion of the use of mechanical (parabola, horn, etc.) rotating antenna, and those operated by motorized control systems in general, and has created a trend in the art towards solutions using phased array antennae with linear or planar extensions, in which each individual radiating element is supplied by an individual solid state transceiver module (TX/RX) based on a gallium arsenide (GaAs) MMIC.
The present invention proposes a dual transceiver module operating at microwave frequencies for configurable phased array antennae, for application to both double and single array antennae, and including a radio frequency circuit comprising a switch at one input and two outputs driving a Lange coupler, whose two outputs are connected to two microwave amplifiers whose outputs are coupled by a further Lange coupler, the dual transceiver module incorporating digital and analog circuitry for controlling its operating modes, the said further Lange coupler being designed to supply microwave frequency energy to a first and a second array or parts of a phased array antenna, through first and second circulators, designed to direct the signals received in reception from the first and second arrays or parts of the phased array antenna towards a reception circuit. Thus, the switch having two outputs is connected to the Lange coupler inputs.
The present invention will now be described with reference to a currently preferred embodiment thereof, described by way of illustration and without restrictive intent on the basis of the attached figures of drawings, in which:

Figure 1 shows a first arrangement according to the prior art for driving two radiating elements of a phased array antenna, in its general and elementary aspects;

Figure 2 shows a partial diagram of a second conventional arrangement for driving two arrays of radiating elements of phased array antennae, using switches between individual modules and radiating elements of two arrays;

Figure 3 shows a schematic block diagram of the solution according to the invention for driving two arrays of phased elements by means of a single array of transceiver elements (TX/RX);

Figure 4 shows a simplified diagram of the arrangement according to the invention focused on the switch having the two outputs connected to the Lange coupler inputs;

Figures 4a and 4b show in detail a Lange coupler with reference to two positions of the RF switch (one way, two outputs); and

Figure 5 shows a general block diagram of the arrangement according to the present invention.

Detailed description of the invention

The prior art solution

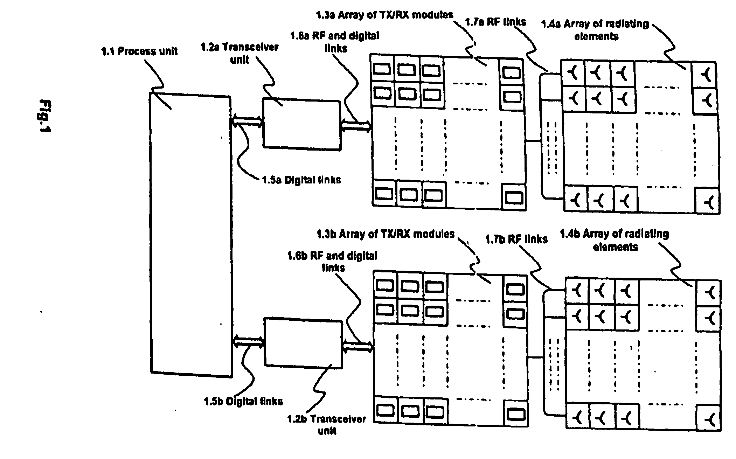

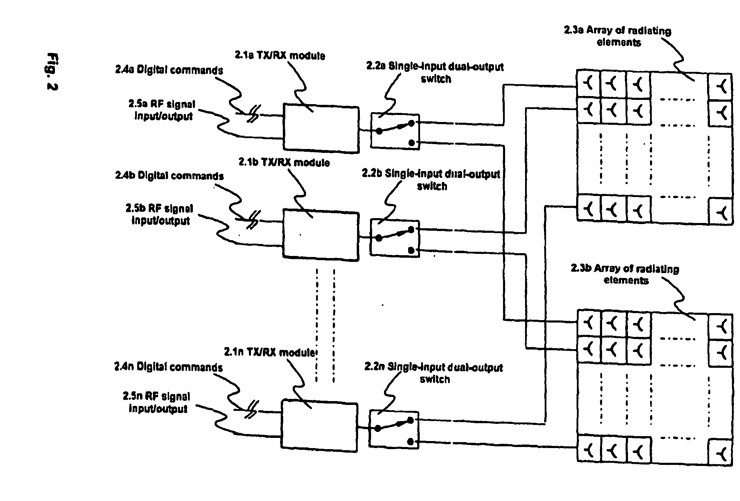

A first prior art solution is shown in Figure 1, which represents the diagram of an antenna system consisting of two adjacent planar arrays, each orientated towards a different spatial sector to provide an azimuthal coverage of at least 180°. As shown in Figure 1, which represents the layout currently used for this type of antenna, each radiating element is driven by a single TX/RX module which receives individual actuation commands from a process unit of the system and exchanges the input and output RF signals with the transceiver. In particular, Figure 1 shows a process unit 1.1 connected by means of digital links 1.5a and 1.5b to a first transceiver unit 1.2a and 1.2b. Further digital radio frequency links 1.6a and 1.6b interconnect a first array of TX/RX modules 1.3a and a second array of TX/RX modules 1.3b. These arrays of TX/RX modules contain the reception and transmission circuits of transmission/reception switches, etc., as is well known to those skilled in the art.

The array of TX/RX modules 1.3a is connected through a set of RF links 1.7a to a first array of radiating elements 1.4a. In the same way, a set of radio frequency links 1.7b connects the array of TX/RX modules 1.3b to the second array of radiating elements 1.4b.

The principal advantages of this configuration are as follows:

- the radiated power is directly proportional to the number of elements in the array;
- if any of the radiating elements fails, the degradation of the system's performance is acceptable.

On the other hand, the disadvantages are as follows:

- a cost directly proportional to the number of radiating elements used;
- the high mechanical and structural complexity, and the consequent complexity of maintenance.

The extremely critical nature of the cost parameter must be emphasized. This is because, in order to achieve the performance required of modern microwave systems, it is necessary to use antennae with an increasing number of radiating elements and consequently an increasing number of TX/RX modules which, if prior art techniques are used, represent by far the most expensive elements of the cost of the antenna, to the point where some equipment becomes economically unfeasible.

In order to overcome these drawbacks, a solution has been developed in the prior art which theoretically requires the use of only 50% of the TX/RX modules of the solution shown in Figure 1, for the same number of radiating elements.

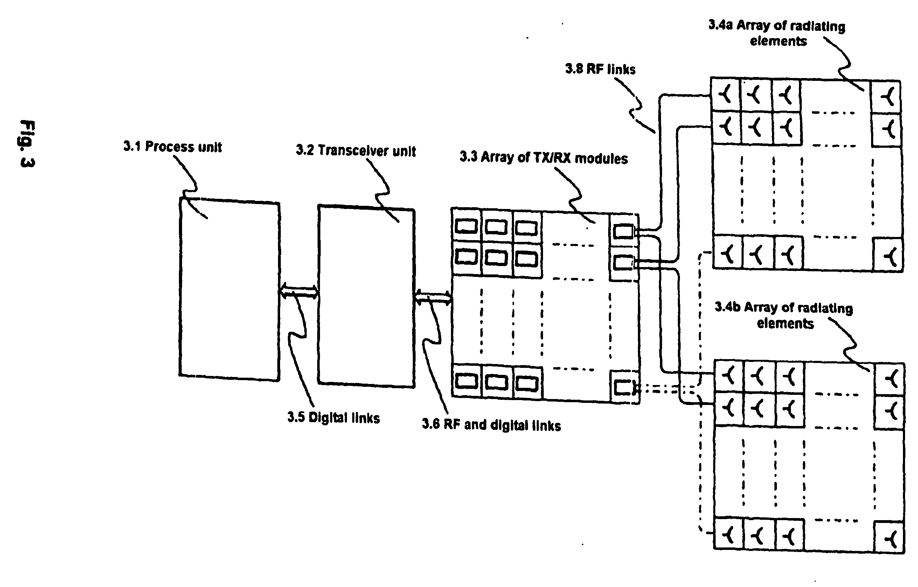

In the solution shown in Figure 2, it could be said that a multiplex technique is used between two arrays of radiating element. Figure 2 starts at the level of the TX/RX modules which appear in the right-hand part of Figure 1.

As shown in Figure 2, the digital commands are indicated by 2.4a, and the RF signal input/output connections for a TX module 2.1a are indicated by 2.5a. The input/output of this TX module 2.1a is connected to single-input dual-output switch 2.2a, which, as shown in the diagram of Figure 2, are connected respectively to a first row of radiating elements of the first array of radiating element 2.3a and to a first row of radiating elements of the second array of radiating elements 2.3b.

For the sake of simplicity, Figure 2 shows a further TX/RX module 2.1b, a second single-input dual-output switch 2.2b, a TX module 2.1n, and a single-input dual-output switch 2.2n which, respectively, drive corresponding rows of radiating elements. The other blocks and circuit connections are indicated by 2.4b, 2.5b, 2.4n and 2.5n. The whole arrangement is evident to those skilled in the art, and it is considered that no further detailed illustration is required.

In this solution, then, each TX/RX module supplies two radiating elements via a fast radio frequency solid state single-input dual-output switch.

The advantages of this solution are as follows:

- a reduction of the number of TX/RX modules and the consequent cost of the antenna, by a factor which is theoretically equal to 50%;
- a reduction of the overall dimensions and the complexity of assembly.

The drawbacks can be summarized as follows:

- it is necessary to use RF switches which can handle high power levels, and which are therefore particularly expensive;
- in transmission, there is a reduction of radiated power for an equal number of radiating elements;
- in reception, there is a reduction of the reception sensitivity of the equipment for an equal number of radiating elements;
- moreover, there is a deterioration of the characteristic of degradation of performance in case of failure, due both to the smaller number of TX/RX modules and to the introduction of the RF switches, constituting additional components which may be subject to failure.

It was stated above that the reduction in cost of the antenna can only theoretically approach 50%.

This is because it must be taken into account that the introduction of the RF switches gives rise to two sets of problems. The first of these is clearly a cost additional to that of the 50% of the TX/RX modules used in the equipment configuration. The second, and predominant factor, is related to the characteristics of the RF switches. This is because even the best of these devices introduce attenuation of the order of 2-3 dB into the radio frequency path, meaning that 40-50% of the radio frequency power passing through them is lost in the form of heat dissipation. The same phenomenon is also present in the case of reception, where an undesired attenuation of the order of 2-3 dB is found. Therefore, the signal received from the antenna is reduced in reception, with a consequent loss of sensitivity of the equipment and also a reduction of the power radiated in transmission.

Consequently, in order not to introduce degradation into the overall performance of the equipment with respect to the known art shown in Figure 1, and in order to meet the equipment specifications, it is necessary to add radiating elements and corresponding TX/RX modules over and above the theoretical 50%. In reality, therefore, for the same performance, the achievable reduction in the cost of the antenna system is in the vicinity of 30%.

The solution according to the present invention

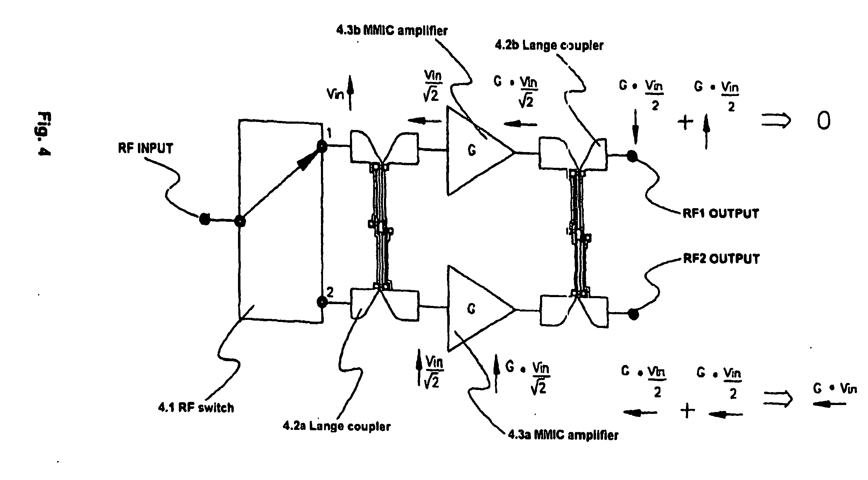

Figure 3 shows in a highly schematic way the solution according to the present invention.

As shown in Figure 3, there is a process unit 3.1, connected by digital links 3.5 to a transceiver unit 3.2. The transceiver unit 3.2 is connected by a set of RF and digital links 3.6 to an array 3.3 of TX/RX modules. As shown on the right-hand side of the block indicated by 3.3, each module is provided with a pair of inputs/outputs connected by RF links to corresponding rows of radiating modules of the first array 3.4a of radiating elements and of radiating modules of the second array 3.4b of radiating elements. The same applies, as shown in the drawing, to the subsequent rows of radiating elements of the first and second arrays of radiating elements. This has led to the development of a TX/RX module with two outputs which provides a real cost saving for the antenna of the order of 50%, while maintaining the technical performance of an equivalent antenna in which each radiating element is supplied by an individual TX/RX module.

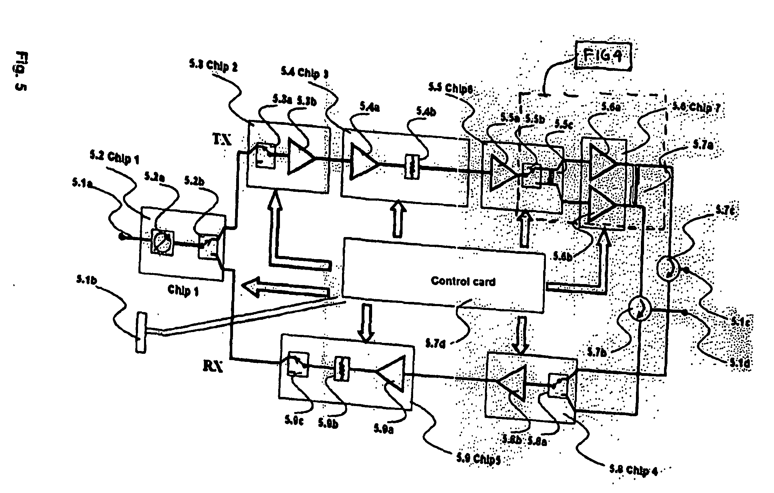

Details of this construction are given below with reference to the description of Figure 5.

The advantages provided by this solution are:

- a cost reduction of 50% by comparison with the reference antenna;
- a radiated power equal to that of the reference antenna;
- a reception sensitivity equal to that of the reference antenna;
- a reduction of the mechanical complexity and overall dimensions of the antenna;
- a greater ease of maintenance if repairs are required following failures of individual elements.

A secondary drawback arises from the fact that, in case of failure of modules, there is a degradation of performance with respect to that of the reference antenna shown in Figures 1 and 2, due to the 50% reduction in TX/RX modules.

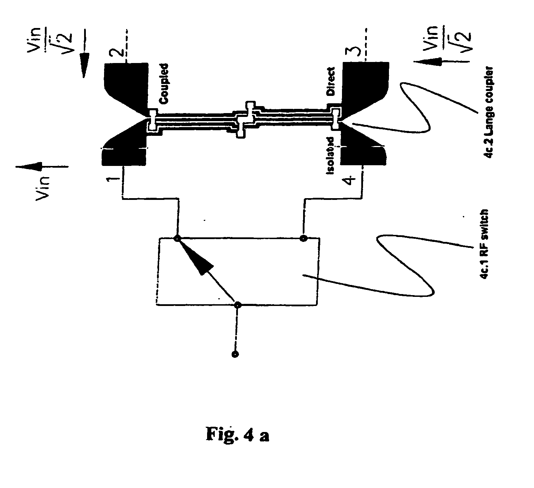

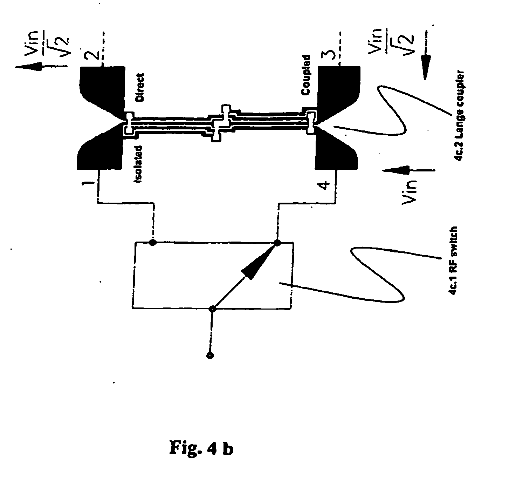

To understand the mode of operation of the TX/RX module with two outputs which forms the core of the present invention, reference may be made to Figure 4, which shows the part of the internal circuit of the module which enables the aforementioned performance to be achieved. The part shown in Figure 2 corresponds to the part of Figure 5 enclosed in the rectangle of broken lines labeled "Figure 4".

The circuit of Figure 4 shows the element 4.1 which is an RF single-input dual-output switch, connected to the two inputs of a balanced amplifier using two Lange couplers indicated by 4.2a and 4.2b, one at the input and one at the output, between which are connected the GaAs MMIC amplifiers 4.3a and 4.3b.

Also with reference to Figure 4, it is assumed that the RF switch 4.1 is initially set to a certain position, for example position "1". Because of the properties of the Lange couplers, it can be demonstrated that an RF signal present at an input of the first coupler is divided into two components of equal amplitude, phase shifted through 90° with respect to each other.

Each of these two components is amplified by the corresponding amplifier 4.3b and 4.3a of the corresponding branch, and appears at the input of the next coupler 4.2b.

At this point the two components are divided and phase shifted in their turn.

At the output of the coupler 4.2b, because of the effect of the phases introduced by this coupler, the phases of all the components are summated at one of the two outputs and are cancelled out at the other. In conclusion, the signal present at one input of the first coupler 4.2a is amplified by the amplifier 4.3b and 4.3a, and appears complete at one output of the second coupler, while at the other output there is theoretically no signal present.

Figure 4 and Figures 4a and 4b also show the vectors representing the signals passing through the system, to clarify the phase combination of the various signals.

Using the theory of transmission lines, and with reference to Figure 4a, which shows the vectors representing the amplitudes of the various signals, it can be noted that the known structure of a Lange coupler consists of four coupled lines, interconnected in pairs.

According to the theory, if a generic signal with amplitude $V_{in}$, frequency f and phase $\varphi_1$, in other words a signal expressed mathematically by $V_{in}\sin(\omega t + \varphi_1)$, where $\omega = 2\pi f$, is present at input 1 in Figure 4a, then two signals given by the following expressions are present at outputs 2 and 3, defined as the coupled and direct output respectively:

a) at the coupled output: $\dfrac{-V_{in}}{\sqrt{2}}\cos(\omega t + \varphi_1)$

b) at the direct output: $\dfrac{V_{in}}{\sqrt{2}}\sin(\omega t + \varphi_1)$

The amplitude of the signal at the coupled output is equal to that of the signal at the direct output, but is phase shifted by 90° in the forward direction, while there is theoretically no signal present at output 4, called the isolated port.
In Figure 4a, the input switch is connected to port 1 of the first Lange coupler, and in this case $V_{in}\sin(\omega t + \varphi_1)$ is the radio frequency signal which is present there.
The signals shown in "a" and "b" will therefore be present at the direct and coupled outputs.
If we now consider the signal present at the coupled output, this will be amplified and sent to the second Lange coupler, where it will undergo a process similar to that described above.

c) $\dfrac{-V_{in}}{\sqrt{2}}\cos(\omega t + \varphi_1)$ at the coupled output of the first Lange coupler

d) $\dfrac{-GV_{in}}{\sqrt{2}}\cos(\omega t + \varphi_2)$ at the input of the second Lange coupler, in which G is the gain of the MMIC amplifier

and $\varphi_2$ is the phase dependent on the path of the signal

e) $\dfrac{-GV_{in}}{2}\sin(\omega t + \varphi_2)$ at the coupled output of the second Lange coupler

f) $\dfrac{-GV_{in}}{2}\cos(\omega t + \varphi_2)$ at the direct output of the second Lange coupler

If we now consider the signal present at the direct output of the first Lange coupler, and repeat the same evaluation, allowing for the fact that, since the Lange coupler is completely symmetrical, the coupled and direct outputs will be interchanged for a signal entering from the port defined above as the isolated port, we find that:

g) $\dfrac{V_{in}}{\sqrt{2}}\sin(\omega t + \varphi_1)$ at the direct output of the first Lange coupler

h) $\dfrac{GV_{in}}{\sqrt{2}}\sin(\omega t + \varphi_2)$ at the input of the second Lange coupler, in

which G is the gain of the MMIC amplifier and $\varphi_2$ is the phase dependent on the path of the signal, considered to be equal to the path of the upper branch

i) $\dfrac{-GV_{in}}{2}\cos(\omega t + \varphi_2)$ at the coupled output of the second Lange coupler

l) $\dfrac{GV_{in}}{2}\sin(\omega t + \varphi_2)$ at the direct output of the second Lange coupler.

In conclusion, the following signals will be present at the RF1 output of Figure 4:

m) $\dfrac{-GV_{in}}{2}\sin(\omega t + \varphi_2) + \dfrac{GV_{in}}{2}\sin(\omega t + \varphi_2) = 0$

while at the RF2 output there will be:

$$n) \quad \frac{-GV_{in}}{2}\cos(\omega t + \varphi_2) - \frac{GV_{in}}{2}\cos(\omega t + \varphi_2) = -GV_{in}\cos(\omega t + \varphi_2)$$

in other words, subject to the introduced phase shifts, the signal at input 1 of the first Lange coupler will be present, amplified G times.

As mentioned previously, owing to the symmetry of these couplers, if the input switch is set to the other position the coupled and direct outputs will be interchanged, as shown in Figure 4b.

For reasons identical to those set out above, the outputs RF1 and RF2 will also be interchanged in respect of the presence of the signals.

Thus it was found that, by changing the setting of the input switch, the whole of the amplified RF power could be directed to one or other of the RF outputs without introducing switching losses.

If the RF switch 4.1 is now set at the input, to output "2" for example, we find that the outputs with no the signal and those with the amplified signal are interchanged. If the setting of the RF input switch 4.1 is then changed, the whole of the transmitted power introduced from the RF input can be sent to one or other of the two radiating elements to which the TX/RX module is connected. Since the internal circuitry of the module has a suitable logical control system for using the amplification function both in transmission and in reception, the whole RF signal received from the individual radiating element is also transmitted to the transceiver unit without degradation.

It should be noted that the RF input switch 4.1, being positioned before the MMIC amplifiers 4.3a and 4.3b in TX mode and after these amplifiers in RX mode, does not have to withstand high transient RF power levels, but only signal power levels, while the design of the MMIC amplifiers prevents losses of radiated power without having any effect on the sensitivity of the equipment.

Consequently, practically all the technical characteristics of the reference antenna are reproduced with a saving of at least 50% in terms of cost, overall dimensions and complexity.

Description of the TX/RX module

With reference to Figure 5, the TX/RX module is a multi-functional integrated component and forms the fundamental component of a phased array antenna for radar systems for location or intentional interference.

The principal functions of the module are as follows:

1) In TX mode, the module amplifies the signal arriving at its input to a suitable output power level, which it sequentially distributes to the two phased array antennae in response to a logical command.

2) In RX mode, the module amplifies the signals received sequentially from the two antennae in the operating band, wile keeping the circuit in linear operating conditions.

3) The module can phase-shift the RF signal in both operating modes, in other words in reception and transmission.

The module consists of a set of seven monolithic gallium arsenide microwave circuits (chips) fitted into three separate containers which are electrically interconnected. The microwave part also comprises two ferrite circulators.

The individual elements are driven by means of a digital control card housing a special silicon integrated circuit (ASIC).

Figure 5 is a block diagram of the module. It shows the following functions:

5.1a - Input RF connector

5.1b - Video connector for power supply and exchange of digital control data.

5.1c and 5.1d - Output RF connectors

5.2 - Chip 1, which houses the functions 5.2a, a wideband RF phase shifter for phase-shifting the transported signal according to the desired positioning of the antenna beam, and a switch 5.2b with one input and two outputs for selection between the transmitting and receiving channels.

5.3 - Chip 2, comprising a single-input dual-output switch, 5.3a, to isolate the transmitting and the receiving channel from each other, and a signal amplifier, 5.3b.

5.4 - Chip 3, comprising a signal amplifier 5.4a, and a digitally controlled attenuator 5.4b, to provide an adequate RF signal level in all conditions of operating temperature.

5.5 - Chip 6, comprising a signal amplifier 5.5a, and a single-input dual-output switch, 5.5b, whose function, together with that of the subsequent Lange coupler 5.5c, has been described with reference to Figure 4.

5.6 - Chip 7, comprising two power amplifiers 5.6a and 5.6b, which have also been described with reference to Figure 4.

5.7a - Output Lange coupler, also forming part of the functions described in Figure 4.

5.7b - and 5.7c - Wideband ferrite circulators used in transmission to direct the RF signal towards the radiating element concerned, via the RF output connectors 5.1c and 5.1d, and used in reception to channel the received RF signal.

5.8 - Chip 4, inserted in the receiving channel and comprising a single-input dual-output switch, 5.8a, for selecting the connection to the radiating element concerned, and a signal amplifier, 5.8b.

5.9 - Chip 5, comprising a signal amplifier 5.9a, a digitally controlled attenuator 5.9b and a single-input dual-output switch 5.9c, for isolating the transmitting and receiving channels from each other in the different operating modes.

5.7d - Control card, containing all the analog and digital circuitry for the power supply and control of the various operating modes of the module.

Operating Modes

The operating modes of the module are:

- TX mode
- RX mode
- Standby mode
- Idle mode

TX mode

In "TX mode", in other words in transmission mode, the signal present on the connector 5.1a is amplified to a required power level and is directed towards one of the two output connectors 5.1c or 5.1d, and then towards the selected phased array antenna.

By operating the digital phase-shifter included in Chip 1 by means of external digital controls, the phase of the output signal can be shifted with respect to the input signal up to a maximum of 337.5° in steps of 22.5°.

The output power can also be reduced by means of an external digital control signal, by operating the digital attenuator included in Chip 3.

RX mode

In "RX mode", in other words in reception mode, the module amplifies the signal received from one of the two selected antennae connected to the module via the connectors 5.1c and 5.1d, and makes it available at the connector 5.1a.

To handle a wide input dynamic range while keeping the reception amplifier in a linear region, the gain of the receiving circuit can be controlled by means of the digital 40 dB dynamics attenuator 5.9b included in Chip 5.

The digital phase-shifter, shared between the transmission and reception paths, thus enables the output phase to be controlled with respect to the input phase in this mode also.

Standby mode

In "Standby mode", the final power amplifier of the transmitting channel can be switched off to minimize power consumption, while keeping the receiving channel operational.

Idle mode

In "Idle mode", the TX and RX channels are both switched off.

Description of the RF circuits

Receiving channel

With reference to Figure 5, the reception channel is constructed from two monolithic gallium arsenide MMIC microwave circuits (Chip 4 and Chip 5).

Both circuits are of the multi-function type and are based on PHEMT technology.

Chip 4 consists of a single-input dual-output switch, for selecting the antenna from which the input signal is to be acquired.

The subsequent attenuator enables the input power level to be controlled, while the low noise factor gain stage amplifies the signal and makes it available at the input of Chip 5.

Chip 5 incorporates three distributed microwave amplifiers and a three-bit digital attenuator.

A single-input dual-output switch is included to increase the isolation between the RX and TX channels when the module is transmitting.

The attenuators formed in Chip 5 have a phase which remains unchanged for any attenuation level which may be introduced.

Finally, a single-input dual-output switch enables or disables the reception path, according to a digital command.

Thus the isolation between the TX and RX paths can be increased, reducing the possibility of initiating undesired oscillation.

Transmitting channel

With reference to the block diagram of the module, the amplification function in transmission mode is provided by Chip 2, Chip 3 and Chip 6.

Chip 2 consists of a single-input dual-output switch and two distributed amplifier stages.

The single-input dual-output switch 5.3a can be used to select the TX channel when operating in transmission mode and to increase the isolation between the transmitting and receiving channels in reception mode.

Chip 3 consists of two distributed amplifier stages and a 4-bit digital attenuator 5.4b.

Chip 6 acts as a driver amplifier for the following Chip 7, the power amplifier.

Chip 6 also includes a single-input dual-output switch 5.5b, used to direct the signal to one of the two outputs, and therefore enabling the desired phased array antenna to be selected for the requisite period, on the basis of a command received from the control card.

The RF signal can be sent via this switch to one or other of the two inputs of a 3 dB Lange coupler. Each of the outputs of this coupler is connected to a power MMIC 5.6a, 5.6b located in Chip 7. The two MMICs supply another 3 dB Lange coupler 5.7a.

As mentioned previously, the electrical properties of this configuration are such that the sum of the RF power generated by the two MMICs of Chip 7 appears at one or other of the two outputs of the final Lange coupler, according to the setting of the single-input dual-output switch 5.5b of Chip 6, and is then directed towards the radiating element of the selected antenna.

It should be noted that, subject to path losses, the whole power generated by the power MMICs is available at the selected antenna, regardless of which one is selected, without any loss of power in switching between the two.

Chip 7, the power amplifier, whose function has been described above, is the final element in the transmitting circuit, is made to operate in saturation to provide the maximum power to the antenna, and is a GaAs MMIC from the manufacturer's catalogue.

Common RF parts

A 4-bit phase-shifter 5.2a is shared between the transmitting and receiving circuits.

Chip 1 includes the phase-shifter 5.2a with a quantization interval of 22.5°, and a single-input dual-output switch 5.2b used to select the TX or RX channel.

Control Circuit

The control circuitry is fitted inside the mechanical part of the module.

It has the function of providing the electrical interfaces between the microwave parts and the control system of the equipment in which the operating software resides. It also has the function of distributing the power supply to the various components of the TX/RX module and of directing the appropriate actuation commands for selecting the operating modes.

The control circuitry must also be capable of storing a certain number of operating parameters, to drive and supply the module in a suitable way according to the required modes.

In order to operate under the control of the equipment software, the control card uses a silicon integrated circuit (ASIC).

Technological aspects

If we examine the TX/RX module according to the present invention in greater detail, it becomes clear that the solution adopted has numerous technological characteristics which are briefly described below:

- the possibility of supplying two different phased array sections or antennae.

The solution adopted, which is internal to the module, does not use external switches, as is the case with the conventional solution, and it ensures that all the RF power generated is available at each of the two antennae, without losing a significant percentage of the transported RF power, while it dispenses with the power supply and control circuitry which the switches would require.

- Dual application, for both double and single array antennae.

The circuit configuration used, as shown in Figure 4, enables all the transported power to be directed to or from one or other of the arrays of radiating elements connected to the output connectors, without any loss of performance. It is therefore possible to use the same TX/RX module in single-array systems by configuring it permanently on one of the two outputs.
This makes it unnecessary to develop, produce and control a different module for the specific application, with evident benefits in terms of logistics in respect of the parts concerned.

- Level of integration of the MMICs

All MMICs which have been developed incorporate a large number of elementary functions, thus eliminating all the problems relating to interconnection and mismatching between them.

- Use of a controlling integrated circuit (ASIC).

The development of an application-specific integrated circuit (ASIC) has made it possible to concentrate in a very small space all the complex functions of driving and supplying the microwave circuitry which were previously incorporated in a card of considerable size, and has also provided considerable economic savings.

- RF-Video integration

The availability of a small ASIC integrated circuit makes it possible to integrate the RF functions and all the low-frequency circuitry (power supply and control) in a single container. This has yielded faster guaranteed operating times, immunity from external interference, the elimination of linking cables and connectors and a greater overall reliability of the system.

Economic effects

As is evident from the circuit description of the TX/RX module, the chosen solution has yielded the following advantages:

- The complexity of the circuitry associated with the requirement of switching the RF signal between two antennae is reduced.
- The corresponding losses are eliminated.
- Only 50% of the modules required to supply the two antennae are used, while the same performance is maintained.

In relation to the technology used, the use of GaAs MMIC circuits has reduced the number of microwave components of the hybrid solution, which is in excess of twenty, to only seven MMIC chips.
These MMICs are made by automated processes on GaAs substrates.
The advantage of this technology is that, during the manufacture of the TX/RX modules, all the adjustment and calibration steps relating to individual components of the circuits are eliminated, since the process of constructing MMIC chips is highly repetitive.
Moreover, the number of soldered connections between the various circuit elements has been reduced, and it has become feasible to assemble the TX/RX modules by means of automatic industrial machines.
The problems relating to manual operation are reduced to a minimum, owing to the reduced intervention of human operators.
All these factors have made it possible to reduce the production cost of a single TX/RX module based on GaAs MMIC chips by an amount ranging from a third to a quarter of the cost of an equivalent module made from discrete components, with a considerable saving in production time. The use of the two-output configuration has made it possible to halve the number of modules required to drive multiple-section phased array antennae, thus reducing the cost of an antenna, which is often the most expensive part of the equipment, by a factor ranging from 6 to 8.

These factors have a direct and highly positive effect on the cost of the whole radar system, since, as mentioned above, the new generation of equipment requires the use of thousands of TX/RX modules.

Since phased array antennae represent one of the most significant parts of the value of the equipment, the reduction of the cost of antennae makes it possible to achieve a pre-eminent position in the highly competitive market for radar systems, and also to penetrate areas of the market not considered previously.

The type of technological solution used is not limited to the applications of which examples are given above, but can be applied to other fields of the art and/or to new microwave systems.

In particular, the TX/RX modules according to the present invention are suitable for a wide range of applications in radar systems, in which there is a trend towards wideband solutions using phased array antennae with multiple sections.

Additionally, in the case of multi-purpose antennae in microwave systems, there is an operational requirement for systems of the next generation, including radar and other systems, to share the same phased array antennae among equipment belonging to different categories and having different operational requirements.

Finally, a further area of development of the equipment to which the present invention relates is associated with new communication systems of the point-to-point, multipoint, wideband Internet, satellite and similar types.

## Claims

1. A dual transceiver module operating wideband at microwave frequencies for configurable phased array antennae for application to both single and double array antennae (3.4a, 3.4b), and including a radio frequency circuit comprising a single-input dual-output switch (4.1, 4c.1, 5.5b) driving a Lange coupler (4.2a, 4c.2, 5.5c), whose two outputs are connected to two microwave amplifiers (4.3a, 4.3b, 5.6a, 5.6b) whose outputs are coupled by a further Lange coupler (4.2b, 5.7a), the dual transceiver module incorporating digital and analogue circuitry for controlling its operating modes; the said further Lange coupler being designed to supply microwave frequency energy to a first and a second array or parts of a phased array antenna, through first and second circulators (5.7b, 5.7c), designed to direct the signals received in reception from the first and second arrays or parts of the phased array antenna towards a reception circuit.

2. A phased array antenna, comprising radiating elements designed to be driven both in transmission and in reception by means of a dual transceiver module as claimed in claim 1.

3. The phased array antenna as claimed in claim 2, **characterized in that** it consists of two half-antennae with different geometric orientations, in order to provide better coverage than that obtainable with a single array of radiating elements.

4. The phased array antenna as claimed in any one or more of claims 2 to 3, **characterized in that** the dual transceiver modules are made from gallium arsenide, GaAs, monolithic microwave integrated circuits, MMICs.

5. The phased array antenna as claimed in any one or more of the preceding claims, **characterized in that** the dual transceiver module includes an ASIC circuit for controlling the functions located within the transceiver modules.

## Patentansprüche

1. Ein duales Transceivermodul, das in einem Breitband in Mikrowellenfrequenzen für konfigurierbare phasengesteuerte Gruppenantennen arbeitet, für eine Anwendung auf sowohl einzelne als auch doppelte Antennenanordnungen (3.4a, 3.4b), und das eine Funkfrequenzschaltung enthält, umfassend einen Einzeleingangs-Dualausgangs-Schalter (4.1, 4c.1, 5.5b), der einen Lange-Koppler (4.2a, 4c.2, 5.5c) ansteuert, dessen Ausgänge mit zwei Mikrowellenverstärkern (4.3a, 4.3b, 5.6a, 5.6b) verbunden sind, deren Ausgänge durch einen weiteren Lange-Koppler (4.2b, 5.7a) gekoppelt sind, wobei das duale Transceivermodul digitale und analoge Schaltungstechnik zum Steuern seiner Betriebsmodi einbezieht; der weitere Lange-Koppler gestaltet ist, Mikrowellenfrequenzenergie einem ersten und einem zweiten Feld oder Teilen einer phasengesteuerten Gruppenantenne zuzuführen, durch erste und zweite Zirkulatoren (5.7b, 5.7c), die gestaltet sind, die Signale, die in Empfang von den ersten und zweiten Feldern oder Teilen der phasengesteuerten Gruppenantenne empfangen werden, zu einer Empfangsschaltung zu lenken.

2. Eine phasengesteuerte Gruppenantenne, umfassend Abstrahlungselemente, die gestaltet sind, sowohl in Übertragung als auch in Empfang mittels eines dualen Transceivermoduls angesteuert zu werden, wie in Anspruch 1

EP 1 630 570 B1

beansprucht.

**3.** Die phasengesteuerte Gruppenantenne, wie in Anspruch 2 beansprucht, **gekennzeichnet dadurch, dass** sie aus zwei Halbantennen mit unterschiedlichen geometrischen Ausrichtungen besteht, um bessere Abdeckung vorzusehen, als sie mit einem einzelnen Feld von Abstrahlungselementen erreichbar ist.

**4.** Die phasengesteuerte Gruppenantenne, wie in einem beliebigen oder mehr von Ansprüchen 2 bis 3 beansprucht, **gekennzeichnet dadurch, dass** die dualen Transceivermodule aus monolithischen mikrowellenintegrierten Schaltungen, MMIC, aus Galliumarsenid, GaAs, hergestellt sind.

**5.** Die phasengesteuerte Gruppenantenne, wie in einem beliebigen oder mehr der vorangehenden Ansprüche beansprucht, **gekennzeichnet dadurch, dass** das duale Transceivermodul eine ASIC-Schaltung zum Steuern der Funktionen enthält, die sich innerhalb der Transceivermodule befinden.

## Revendications

**1.** Module d'émetteur-récepteur double fonctionnant dans une large bande à des fréquences de micro-onde pour des antennes à réseau à commande de phase configurables pour application à la fois à des antennes à réseau simple et double (3.4a, 3.4b), et comprenant un circuit de fréquence radio comprenant un commutateur à entrée unique et sortie double (4.1, 4c.1, 5.5b) commandant un coupleur de Lange (4.2b, 4c.2, 5.5c), dont deux sorties sont reliées à deux amplificateurs de micro-onde (4.3a, 4.3b, 5.6a, 5.6b) dont les sorties sont couplées par un autre coupleur de Lange (4.2b, 5.7a), le module d'émetteur-récepteur double incorporant un circuit numérique et analogique destiné à commander ses modes de fonctionnement; ledit autre coupleur de Lange étant conçu pour délivrer une énergie de fréquence de micro-onde à un premier et un deuxième réseau ou des parties d'une antenne à réseau à commande de phase, par l'intermédiaire de premier et deuxième circulateurs (5.7b, 5.7c), conçus pour diriger les signaux reçus dans la réception des premier et deuxième réseaux ou parties de l'antenne à réseau à commande de phase vers un circuit de réception.

**2.** Antenne à réseau à commande de phase, comportant des éléments de rayonnement conçus pour être commandés à la fois en émission et en réception au moyen d'un module d'émetteur-récepteur double selon la revendication 1.

**3.** Antenne à réseau à commande de phase selon la revendication 2, **caractérisée en ce qu'**elle se compose de deux demi-antennes avec des orientations géométriques différentes, afin de procurer une meilleure couverture que celle pouvant être obtenue avec un unique réseau d'éléments de rayonnement.

**4.** Antenne à réseau à commande de phase selon l'une quelconque ou plusieurs des revendications 2 et 3, **caractérisée en ce que** les modules d'émetteur-récepteur doubles sont fabriqués à partir de circuits intégrés à micro-onde monolithiques, MMIC, à l'arséniure de gallium, GaAs.

**5.** Antenne à réseau à commande de phase selon l'une quelconque ou plusieurs des revendications précédentes, **caractérisée en ce que** le module d'émetteur-récepteur double comprend un circuit ASIC destiné à commander les fonctions qui se trouvent dans les modules d'émetteur-récepteur.

12

**Fig.1**

**Fig. 2**

Fig. 3

Fig. 4

4.3b MMIC amplifier

4.2b Lange coupler

RF INPUT

$V_{in}$

$\dfrac{V_{in}}{\sqrt{2}}$

$G \cdot \dfrac{V_{in}}{\sqrt{2}}$

$G \cdot \dfrac{V_{in}}{2} \quad + \quad G \cdot \dfrac{V_{in}}{2} \quad \Rightarrow \quad 0$

G

G

RF1 OUTPUT

RF2 OUTPUT

4.1 RF switch

4.2a Lange coupler

4.3a MMIC amplifier

$\dfrac{V_{in}}{\sqrt{2}}$

$G \cdot \dfrac{V_{in}}{\sqrt{2}}$

$G \cdot \dfrac{V_{in}}{2} \quad + \quad G \cdot \dfrac{V_{in}}{2} \quad \Rightarrow \quad G \cdot V_{in}$

EP 1 630 570 B1

16

Fig. 4 a

EP 1 630 570 B1

Fig. 4 b

18

Fig. 5